# EUROPEAN PATENT APPLICATION

(11) **EP 1 909 310 A1**
(43) Date of publication of application: **09.04.2008**
(21) Application number: 06768071.0
(22) Date of filing: 11.07.2006
(51) Int. Cl.: H01L 21/027, G03F 7/20

(54) **EXPOSURE APPARATUS AND METHOD FOR MANUFACTURING DEVICE**

(30) Priority: 11.07.2005 JP 2005201582
(71) Applicant: NIKON CORPORATION, Tokyo 100-8331 (JP)
(72) Inventor: MIZUTANI, Takeyuki, c/o NIKON CORPORATION, Tokyo 100-8331 (JP); OKUMURA, Masahiko, c/o NIKON CORPORATION, Tokyo 100-8331 (JP); KOHNO, Hirotaka, c/o NIKON CORPORATION, Tokyo 100-8331 (JP)
(74) Representative: Viering, Jentschura & Partner
(86) International application number: PCT/JP2006/313758
(87) International publication number: WO 2007/007746

(57) **Abstract**

An exposure apparatus (EX) is provided with a first stage (WST) and a second stage (MST). A maintenance apparatus (55) carries out maintenance on the second stage (MST) during exposure processing of a wafer (W) held on the first stage.

## Description

### TECHNICAL FIELD

The present invention relates to an exposure apparatus that transfers a mask pattern onto a substrate, and to a device manufacturing method that uses this exposure apparatus.

Priority is claimed on Japanese Patent Application No. 2005-201582, filed July 11, 2005, the contents of which are incorporated herein by reference.

### BACKGROUND ART

In a lithographic process, which is one of the processes for manufacturing devices such as semiconductor devices, liquid crystal display devices, image pickup devices (such as charge coupled devices (CCD) and the like), and thin-film magnetic heads and the like, an exposure apparatus is used in order to transfer a pattern of a mask in the form of a reticle via a projection optical system onto a substrate in the form of a wafer (or glass plate or the like) onto which photoresist has been coated. Alternatively, a scan exposure type of projection exposure apparatus (i.e., a scan exposure apparatus) such as a scanning stepper may be used.

In recent years, there have been demands for improvements in exposure accuracy (i.e., in resolution, transfer fidelity, superpositioning accuracy, and line width errors and the like) in order to obtain greater device integration. From the standpoint of improving device manufacturing efficiency, there have also been demands for an improvement in throughput (i.e., the number of wafers that can be exposure processed per unit time). In order to respond to these demands, improvements in the accuracy and speed of the wafer stage which holds the wafer, as well as a reduction in the time required for the various measurements that are performed prior to the exposure processing and also an improvement in the accuracy of these measurements have been achieved.

In order to achieve the aforementioned improvements in exposure accuracy and throughput simultaneously, an exposure apparatus has been developed that is provided with a twin stage which has two wafer stages.

In Patent document 1 mentioned below, an exposure apparatus is disclosed in which a further improvement in exposure accuracy and a smaller footprint are achieved by separating the various measurement instruments from the wafer stage and providing a measurement stage that is provided with the various measurement instruments separately from the wafer stage. Moreover, in recent years, liquid immersion type exposure apparatuses have also been developed in which, in order to improve the resolution, a portion between a projection optical system and a wafer is filled with a liquid which has a higher refractive index than that of air, thereby increasing the numerical aperture and achieving an improvement in resolution.
[Patent document 1] Japanese Patent Application, Publication No. H11-135400

### DISCLOSURE OF INVENTION

### PROBLEMS TO BE SOLVED BY THE INVENTION

While it is expected that there will be further demands in the future for improvements in throughput, it is also considered that there will be demands for improvements in exposure accuracy. Moreover, even in the aforementioned exposure apparatus which is provided with a plurality of wafer stages, and in an exposure apparatus which is provided with a wafer stage and a measurement stage as well, various types of maintenance are performed at regular intervals in order to maintain the desired performance. If it is possible to shorten the time required for this maintenance, then it follows that the time the exposure apparatus can spend in operation can be lengthened, which results in it being possible to achieve an improvement in throughput.

Moreover, in a large number of current exposure apparatuses, the chamber interiors where the wafer stages are placed are temperature controlled to a high degree of accuracy. As a result, measurement errors by the laser interferometer measuring the position of the wafer stage are reduced, and expansion or contraction of the components that form the wafer stage which are caused by changes in temperature are prevented. Even in the aforementioned exposure apparatus which is provided with a plurality of wafer stages, and in the exposure apparatus which is provided with a wafer stage and a measurement stage as well, the chamber interiors are temperature controlled to a high degree of accuracy, however, there is a tendency for temperature-controlled air (i.e. gas) to stagnate in the spaces between the respective stages, and it may be considered that there is a possibility that the exposure accuracy will deteriorate as a result of this.

It is an aim of the present invention to provide an exposure apparatus and a device manufacturing method which uses this exposure apparatus that make it possible to achieve further improvements in exposure accuracy and throughput.

### MEANS FOR SOLVING THE PROBLEM

The present invention employs the following structure which is associated with the respective drawings illustrated in the embodiments. However, the bracketed symbols attached to various elements simply show an example of those elements and are not limiting thereof.

According to a first aspect of the present invention, there is provided an exposure apparatus (EX), comprising a first stage (WST); a second stage (MST); a maintenance apparatus (55) that carries out maintenance on the second stage; and a control apparatus (20) that causes the maintenance performed by the maintenance apparatus to be executed during exposure processing of a substrate (W) that is placed on the first stage.

According to this invention, maintenance is carried out on the second stage by the maintenance apparatus under the control of the control apparatus while exposure processing is being performed on a substrate placed on the first stage.

According to a second aspect of the present invention, there is provided an exposure apparatus, comprising a plurality of stages (WST and MST), wherein one of the stages of the plurality of stages is provided with a temperature control apparatus (81 to 84) that controls the temperature of at least one of the one stage or the other stage by controlling the flow of gas in a space between the one stage and the other stage.

According to this invention, using a temperature control apparatus that is provided on one stage of a plurality of stages, the flow of gas in a space between this stage and the other stage is controlled, so that the temperature of at least one of these stages is controlled.

A device manufacturing method according to the present invention includes a step of transferring a device pattern onto a substrate using any one of the above-described exposure apparatus.

An exposure method according to the present invention is an exposure method for exposing a substrate in which predetermined processing is executed using a first stage that holds the substrate, and during the predetermined processing, maintenance is carried out on a second stage that is different from the first stage.

A device manufacturing method according to the present invention includes exposing the substrate using the above described exposure method.

### EFFECTS OF THE INVENTION

According to the present invention, because maintenance is carried out on the second stage by the maintenance apparatus under the control of the control apparatus while exposure processing is being performed on a substrate placed on the first stage, it is possible to improve the operational efficiency of the exposure apparatus. As a result, the effect is obtained that it is possible to achieve a further improvement in throughput.

Moreover, according to the present invention, using a temperature control apparatus that is provided on one stage of a plurality of stages, the flow of gas in a space between this one stage and the other stage is controlled, so that the temperature of at least one of these stages is controlled. Because of this, the effect is achieved that it is possible to improve exposure accuracy and the like.

Moreover, according to the exposure method of the present invention, the effect is obtained that it is possible to achieve a further improvement in throughput.

Furthermore, according to the device manufacturing method of the present invention, because it is possible to achieve further improvements in exposure accuracy and throughput, the effect is achieved that it is possible to efficiently manufacture a micro device. As a result, an improvement in yield can be expected and, furthermore, it is also possible to decrease manufacturing costs of a device being manufactured.

### BRIEF DESCRIPTION OF THE DRAWINGS

FIG. 1 is a side view showing the schematic structure of an exposure apparatus according to an embodiment of the present invention.
FIG. 2 is a perspective view showing the structure of a stage apparatus.
FIG. 3 is a block diagram showing the structure of a control system of an exposure apparatus.
FIG. 4A is a view showing an example of the structure of a maintenance apparatus.
FIG. 4B is a view showing an example of the structure of a maintenance apparatus.
FIG. 5 is a view showing an example of the structure of a maintenance apparatus.
FIG. 6 is a perspective view showing another example of the structure of a maintenance apparatus.
FIG. 7 is a side view showing a position measurement device that is provided in the maintenance apparatus shown in FIG. 6.
FIG. 8A is a view showing a temperature control device provided in a measurement stage.
FIG. 8B is a view showing a temperature control device provided in a measurement stage.
FIG. 9 is a view showing a temperature control device provided in a measurement stage.
FIG. 10 is a flowchart showing an example of a micro device manufacturing process.

### DESCRIPTION OF THE REFERENCE SYMBOLS

20 ... Main control apparatus, 27 ... First drive system, 28a, 28b ... Second drive system, 47 ... First drive system, 48a, 48b ... Second drive system, 53 ... Reference plate, 55 ... Maintenance apparatus, 71 ... Cleaning nozzle, 72 ... Cleaning nozzle, 74 ... Ultraviolet ray lamp, 78 ... Position measurement device, 81 ... Temperature control device, 82 ... Exhaust duct, 83, 84 ... Baffle plate, EX ... Exposure apparatus, MST ... Measurement stage, PL ... Projection optical system, W ... Wafer (substrate), WST ... Wafer stage

### BEST MODE FOR CARRYING OUT THE INVENTION

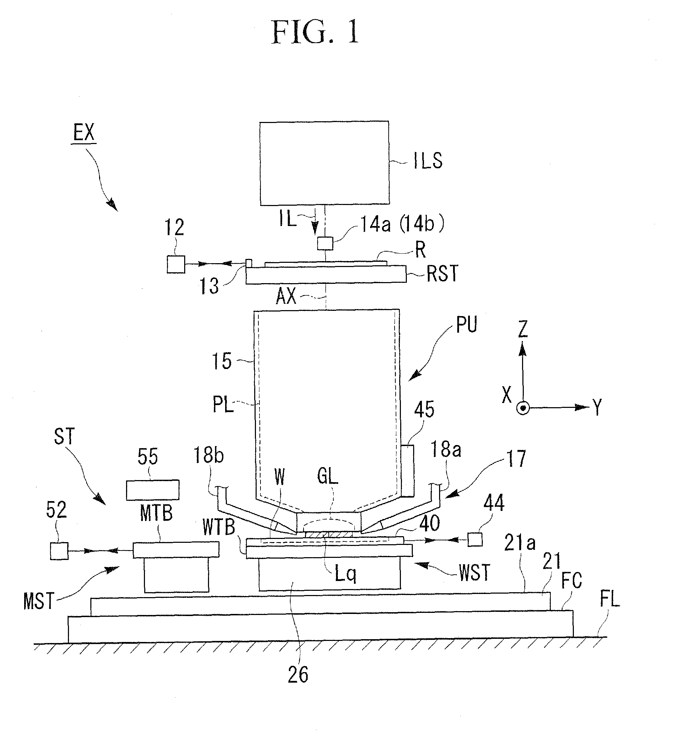

An exposure apparatus and a device manufacturing method according to embodiments of the present invention will now be described in detail with reference made to the drawings. FIG. 1 is a side view showing the schematic structure of an exposure apparatus according to an embodiment of the present invention. An exposure apparatus EX shown in FIG. 1 is a scan exposure type of exposure apparatus which employs a step and scan method in which, while a reticle R serving as a mask and a wafer W serving as a substrate are moved relatively in relation to a projection optical system PL, a pattern which is formed on the reticle R is sequentially transferred onto the wafer W.

Note that in the description given below, where necessary, an XYZ coordinate system is set in the drawings, and positional relationships between respective components are explained with reference made to this XYZ coordinate system. In the XYZ coordinate system shown in FIG. 1, the X axis and the Y axis are set so as to be contained within a plane which is parallel to the plane of movement of the wafer W, while the Z axis is set as a direction which matches an optical axis AX of the projection optical system PL. Moreover, in the present embodiment, the direction in which the reticle R and the wafer W are moved in synchronization (i.e., the scanning direction) is set as the Y direction.

As is shown in FIG. 1, the exposure apparatus EX of the present embodiment includes an illumination optical system ILS, a reticle stage RST which holds the reticle R, a projection unit PU, a stage apparatus ST having a wafer stage WST which holds the wafer W and a measurement stage MST, and a control system which controls these. The illumination optical system ILS illuminates with illumination light (i.e., exposure light) IL having a substantially uniform illumination intensity a slit-shaped illumination area on the reticle R which has been specified by a reticle blind (not shown). Here, ArF excimer laser light (having a wavelength of 193 nm) is used as an example of the illumination light IL.

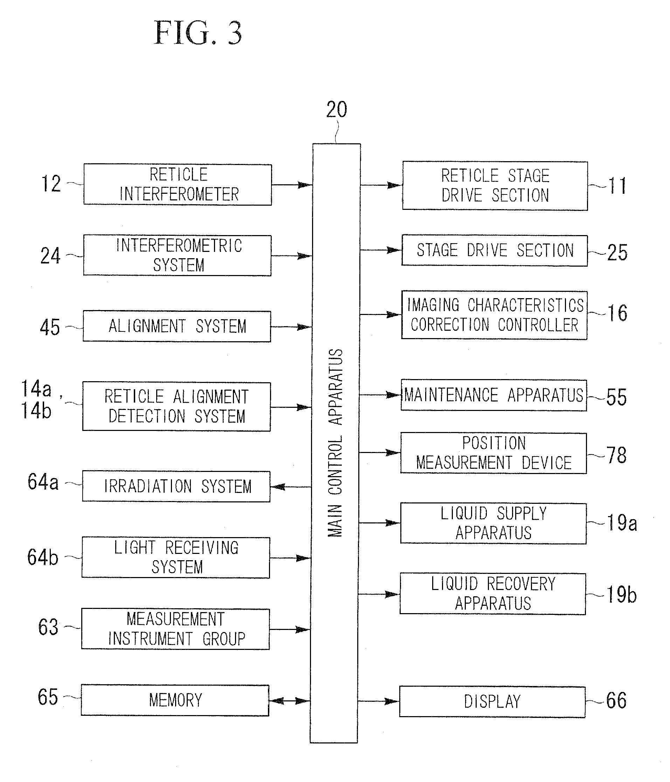

The reticle R on whose pattern surface (i.e., the - Z side surface in FIG. 1) a pattern has been formed is held on the reticle stage RST by, for example, vacuum suction. The reticle stage RST is constructed such that it is able to be driven in micro stages within an XY plane that is perpendicular to the optical axis of the illumination optical system ILS (which matches the optical axis AX of the projection optical system PL (described below)) by a reticle stage drive section 11 (not shown in FIG. 1; see FIG. 3) that includes, for example, a linear motor. In addition, the reticle stage RST is constructed such that it is also able to be driven at a stipulated scanning speed in the scan direction (i.e., the Y direction).

The position (including the rotation around the Z axis) within the stage movement plane of the reticle stage RST is constantly detected at a resolution of, for example, approximately 0.5 to 1 nm by a laser interferometer (referred to below as a reticle interferometer) 12 via a movable mirror 13 (which is actually provided with a Y movable mirror that has a reflective surface that is perpendicular to the Y axis, and an X movable mirror that has a reflective surface that is perpendicular to the X axis). Measurement values from this reticle interferometer 12 are output to a main control apparatus 20 (not shown in FIG. 1; see FIG. 3). The main control apparatus 20 controls the position (and speed) of the reticle stage RST by calculating the position in the X direction, the Y direction, and the θZ direction (which is a rotation direction around the Z axis) of the reticle stage RST based on the measurement values from the reticle interferometer 12, and then controlling the reticle stage drive section 11 based on these calculation results.

A pair of reticle alignment detection systems 14a and 14b that are formed by through-the-reticle (TTR) type alignment systems that use exposure wavelength light are provided at a predetermined distance from each other in the X direction above the reticle stage RST. The reticle alignment detection systems 14a and 14b simultaneously observe a pair of reticle alignment marks on the reticle R and a conjugate image via the projection optical system PL of a pair of reference marks (referred to below as first reference marks) on a measurement stage MST that correspond to these reticle alignment marks. Reticle alignment detection systems having the same type of structure as that disclosed in, for example, Japanese Patent Application, Publication No. H07-176468 (corresponding to United States Patent No. 5,646,413) may be used for the reticle alignment detection systems 14a and 14b.

The projection unit PU includes a lens barrel 15, and the projection optical system PL that includes a plurality of optical elements that are held in a predetermined positional relationship inside the lens barrel 15. A dioptric system that is formed by a plurality of lenses (i.e., lens elements) that have a common optical axis AX in, for example, the Z direction is used for the projection optical system PL.

In the exposure apparatus EX of the present embodiment, in order to perform exposure by employing a liquid immersion method, a liquid supply nozzle 18a and a liquid recovery nozzle 18b of a liquid immersion apparatus 17 are provided in the vicinity of a lens (also referred to below as an front lens) GL serving as a lens element of the projection optical system PL which is positioned closest to an image plane (i.e., the wafer W). One end of a supply tube (not shown) is connected to a liquid supply apparatus 19a (not shown in FIG. 1; see FIG. 3), while another end thereof is connected to the liquid supply nozzle 18a. One end of a recovery tube (not shown) is connected to a liquid recovery apparatus 19b (not shown in FIG. 1; see FIG. 3), while another end thereof is connected to the liquid recovery nozzle 18b.

Here, pure water (referred to below simply as 'water' except in special cases where another descriptor is required) through which ArF excimer laser light (i.e., light having a wavelength of 193 nm) is able to pass is used as the aforementioned liquid. Pure water has the advantages that it can be easily obtained in large quantities by semiconductor manufacturing plants and the like and that it has no harmful effects on the photoresist that is coated on the wafer W or on optical lenses and the like. Here, the refractive index n of water is substantially 1.44, and the wavelength of the illumination light IL is shortened to 134 nm (193 nm x 1/n = 134 nm). It is also possible to supply a liquid whose temperature is substantially the same as that of the wafer W so as to form a liquid immersion area. This makes it possible to prevent any thermal deformation of the wafer W that is caused by any difference in temperature between the wafer W and the liquid.

The liquid supply apparatus 19a opens a valve which is connected to a supply tube to a predetermined opening angle in accordance with a command from the main control apparatus 20, and supplies water via the liquid supply nozzle 18a to an area between the front lens GL and the wafer W. The liquid recovery apparatus 19b opens a valve which is connected to a recovery tube to a predetermined opening angle in accordance with a command from the main control apparatus 20, and recovers water into the interior of the liquid recovery apparatus 19b (i.e., a tank for liquid) from the area between the front lens GL and the wafer W via the liquid recovery nozzle 18b. At this time, the main control apparatus 20 issues commands to the liquid supply apparatus 19a and the liquid recovery apparatus 19b such that the amount of water that is supplied from the liquid supply nozzle 18a to the area between the front lens GL and the wafer W is always the same as the amount of water that is recovered therefrom via the liquid recovery nozzle 18b. Accordingly, a constant amount of water Lq (see FIG. 1) is maintained between the front lens GL and the wafer W. Note that the water Lq that is held between the front lens GL and the wafer W is constantly being replaced.

As has been described above, the liquid immersion apparatus 17 of the exposure apparatus of the present embodiment is a local liquid immersion apparatus that includes the liquid supply apparatus 19a, the liquid recovery apparatus 19b, a supply tube, a recovery tube, the liquid supply nozzle 18a, and the liquid recovery nozzle 18b and the like.

The stage apparatus ST includes a frame caster FC that is placed, for example, on the floor FL of a semiconductor plant, a baseboard 21 that is provided on top of the frame caster FC, a wafer stage WST and a measurement stage (MST) that are placed on top of the baseboard 21 and that move along a top surface (i.e., a moving surface) of the baseboard 21, an interferometric system 24 (see FIG. 3) that includes Y axis interferometers 52 and 44 that detect the positions of the stages WST and MST, and a stage drive section 25 (see FIG. 3) that drives the stages WST and MST. The aforementioned wafer stage WST holds and moves a wafer W in order that the pattern on the reticle R can be transferred by exposure onto the wafer W. In contrast, during the period in which the wafer stage WST is not facing the projection optical system PL, for example, while the wafer stage WST is positioned in a loading position in order for a wafer W to be replaced, the measurement stage MST is positioned below the projection optical system PL and performs various types of measurements. Note that the liquid immersion apparatus 17 is able to fill the area between the front lens GL of the projection optical system PL and the wafer stage WST and the area between the front lens GL of the projection optical system PL and the measurement stage MST with water.

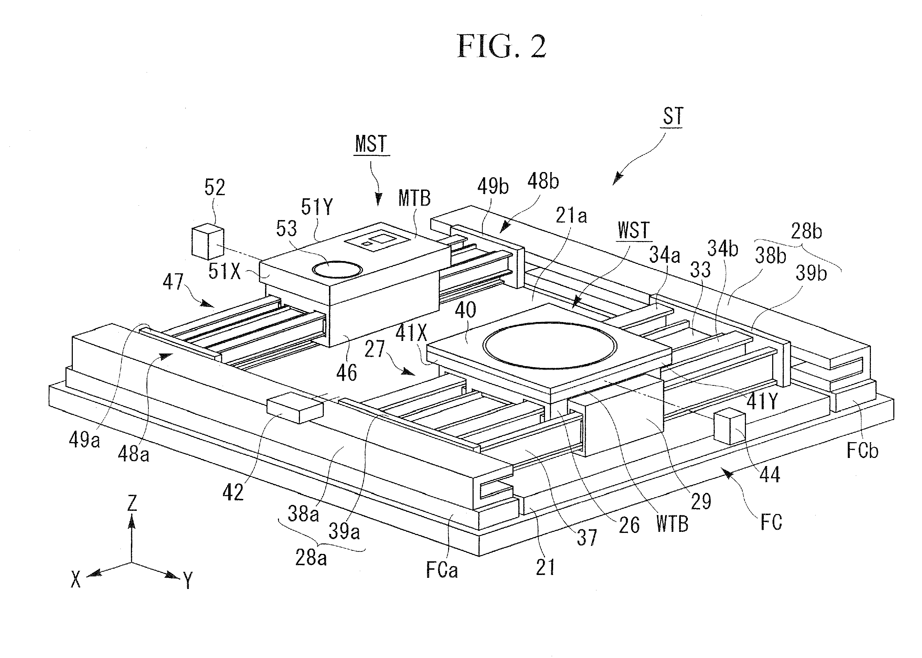

Next, the structure of the stage apparatus ST will be described in detail. FIG. 2 is a perspective view showing the structure of the stage apparatus ST. As is shown in FIG. 2, the frame caster FC is formed schematically in a plate shape having protruding portions FCa and FCb, which extend longitudinally in the Y direction and protrude upwards, formed in the vicinity of one end side and another end side in the X direction integrally with the frame caster FC. The baseboard (i.e., surface plate) 21 is placed on an area bounded by the protruding portions FCa and FCb of the frame caster FC. A top surface 21a of the baseboard 21 is finished to an extremely high degree of flatness, and forms a guide surface for movement of the wafer stage WST and the measurement stage MST on the XY plane.

As is shown in FIG. 2, the wafer stager WST includes a wafer stage main body 26 that is placed on the base board 21, and a wafer table WTB that is mounted on the wafer stage main body 26. The wafer stage main body 26 is formed by a hollow component which has a rectangular frame-shaped cross section and extends in the X direction. A mechanical gravity canceller is provided at a bottom surface of the wafer stage main body 26. This mechanical gravity canceller has a supporting portion that supports the wafer stage WST by pressurizing the interior of a bellows, and an air bearing portion that faces the moving surface 21 a which serves as a guide surface and causes the wafer stage WST to float above the moving surface 21a.

Moreover, the wafer stage WST is provided with a first drive system 27 that drives the wafer stage main body 26 in a long stroke in the X direction, and that drives the wafer stage main body 26 in micro steps in the Y direction, the Z direction, the θx direction (i.e., a rotation direction around the X axis), the θy direction (i.e., a rotation direction around the Y axis), and the θz direction (i.e., a rotation direction around the Z axis), and second drive systems 28a and 28b that drive the wafer stage main body 26 and the first drive system 27 in a long stroke in the Y direction. The wafer stage WST is provided with a tube carrier 29 that moves at a uniform speed in the X direction, and a six degree-of-freedom pipe (not shown) that transmits applied force from a vacuum or air or the like from the tube carrier 29 to the wafer stage main body 26 without making actual contact therewith. Here, the uniform motion in the X direction of the tube carrier 29 is in order to reduce any effects on the wafer stage main body 26 from the reaction force generated by the driving of the tube carrier 29.

Three apertures are formed respectively on the side surface on the +X side and the side surface on the -X side of the wafer stage main body 26. A Y axis stator 33 that is provided with a plurality of coils is provided so as to penetrate the wafer stage main body 26 via those apertures from among the respective apertures that are formed substantially in a center portion of the respective side surfaces. Moreover, two X axis stators 34a and 34b are provided so as to penetrate the wafer stage main body 26 via each of those two apertures from among the three apertures formed in each side surface that are formed sandwiching in the Y direction the apertures penetrated by the Y axis stator 33. Furthermore, permanent magnets are provided in each of the three aforementioned apertures.

The above described Y axis stator 33 drives the wafer stage main body 26 in micro steps in the Y direction in cooperation with the permanent magnets provided in the apertures penetrated by the wafer stage main body 26. Moreover, the above described two X axis stators 34a and 34b drive the wafer stage main body 26 in a long stroke in the X direction in cooperation with the respective permanent magnets provided in the apertures penetrated respectively by the X axis stators 34a and 34b. Here, by varying the drive amount of the respective X axis stators 34a and 34b, it is possible to rotate the wafer stage main body 26 in the θz direction.

Namely, the first drive system 27 is provided with a moving magnet type of linear motor which is formed by the X axis stators 34a and 34b and permanent magnets, and with a moving magnet type of linear motor which is formed by the X axis stators 34a and 34b and permanent magnets. Note that, here, a description is given of an example in which a moving magnet type of linear monitor is provided, however, it is also possible for a moving coil type of linear monitor to be provided. Moreover, as is described above, the wafer stage WST is a guideless stage which does not have guide components for guiding movement in the X direction.

Two Z axis stators which extend in the X direction and their corresponding permanent magnets (none of which are shown) are provided below the wafer stage main body 26. By individually controlling the driving amount of each Z axis stator, it is possible to drive the wafer stage main body 26 in the Z direction, the θx direction, and the θy direction. In addition, a stator 37 that extends in the X direction is provided in order to drive the tube carrier 29 in the X direction. Note that both ends of each of the above described Y axis stator 33, X axis stators 34a and 34b, Z axis stator, and stator 37 are fixed respectively to movers 39a and 39b that make up the second drive systems 28a and 28b.

Y axis stators 38a and 38b that extend in the Y direction and make up the second drive systems 28a and 28b are placed above the protruding portions FCa and FCb of the frame caster FC. These Y axis stators 38a and 38b are supported floating at a predetermined clearance above the protruding portions FCa and FCb by gas hydrostatic bearings (not shown), for example, air bearings, that are provided at bottom surfaces of the Y axis stators 38a and 38b. This is because the stators 38a and 38b are moved in the opposite direction as Y direction Y counter mass by reaction force that is generated by movement in the Y direction of the wafer stage WST and/or the measurement stage MST, and providing gas hydrostatic bearings compensates for this reaction force in accordance with the law of conservation of momentum.

The above described wafer stage main body 26 and the like are placed between the stators 38a and 38b, and the movers 39a and 39b that are fixed to both ends of the Y axis stator 33, the X axis stators 34a and 34b, the Z axis stator, and the stator 37 are each inserted from the inner side of the stators 38a and 38b. The stators 38a and 38b are provided with permanent magnets that are aligned in the Y direction, while the movers 39a and 39b are provided with coils that are aligned in the Y direction. Namely, the second drive systems 28a and 28b are provided with moving coil type linear motors that drive the wafer stage WST in the Y direction. Note that, here, a description is given of an example in which moving coil type linear monitors are provided, however, it is also possible for moving magnet type linear monitors to be provided.

The wafer stage WST is a guideless stage that, apart from the magnetic coupling between the stator 38a and the mover 39a and the magnetic coupling between the stator 39b and the mover 39b, does not have guide components for guiding movement in the Y direction. Note that the reaction force when the wafer stage WST is driven in the X direction is transmitted to an X counter mass (not shown) via the magnetic couplings between the stators 38a and 38b and the movers 39a and 39b provided in the second drive systems 28a and 28b. This X counter mass is provided between the protruding portions FCa and FCb of the frame caster FC and the stators 38a and 38b, and is able to move in the X direction supporting the stators 38a and 38b that are used for counter mass in the Y direction. As a result of the X counter mass moving in an opposite direction from the movement in the X direction of the wafer stage WST and/or the measurement stage MST, the reaction force when the wafer stage WST is driven in the X direction is compensated. Note that in the stage apparatus ST of the present embodiment, the X counter mass and the Y counter mass are shared by the wafer stage WST and the measurement stage MST, however, it is also possible for just one of these counter masses to be shared by the wafer stage WST and the measurement stage MST.

A wafer holder 40 that holds the wafer W is provided on the wafer table WTB. The wafer holder 40 is provided with a plate-shaped main body portion, and a liquid-repellent (i.e., water-repellent) auxiliary plate that is fixed to a top surface of this main body portion and in the center of which is formed a circular aperture that is larger than the diameter of the wafer W. A number (i.e., a plurality) of pins are placed in the area of the main body portion in the interior of this circular aperture in the auxiliary plate. A wafer W is vacuum suctioned in a state of being supported by this number of pins. In this case, in a state in which a wafer W is being vacuum suctioned, the heights of the surface of this wafer W and the surface of the auxiliary plate are substantially equal. Note that it is also possible to not provide an auxiliary plate and to impart liquid-repellency to the surface of the wafer table WTB.

Moreover, as is shown in FIG. 2, a reflective surface 41X that is perpendicular to the X direction (i.e., extends in the Y direction) is formed by mirror working on one end in the X direction (i.e., the +X side end) of the wafer table WTB. A reflective surface 41Y that is perpendicular to the Y direction (i.e., extends in the X direction) is formed in the same way by mirror working on one end in the Y direction (i.e., the + Y side end) of the wafer table WTB. Interferometric beams (i.e., beams) from an X axis interferometer 42 and a Y axis interferometer 44 that make up the interferometric system 24 (see FIG. 3) are irradiated respectively onto the reflective surfaces 41X and 41Y.

As a result of the X axis interferometer 42 and the Y axis interferometer 44 receiving reflection light respectively from the reflective surfaces 41X and 41Y, they detect displacement in their measurement directions from reference positions (generally, a fixed mirror is placed on a side surface of the projection unit PU, and/or on a side surface of an off-axis type of alignment system 45 (see FIG. 1 and FIG. 3) that is placed on the +Y direction side of the projection optical system PL, and these are used as reference surfaces) of the respective reflective surfaces 41X and 41Y Note that instead of a structure in which the reflective surfaces 41X and 41Y are formed on end surfaces of the wafer table WTB, it is also possible to employ a structure in which a Y movable mirror that has a reflective surface (i.e. 41Y) that extends in the X direction, and an X movable mirror that has a reflective surface (i.e. 41X) that extends in the Y direction are provided respectively on a top surface of the wafer table WTB.

The X axis interferometer 42 has a measurement axis that is parallel to the X axis and passes through the center of projection (i.e., the optical axis AX - see FIG. 1) of the projection optical system PL, and a measurement axis that is parallel to the X axis and passes through the center of a measurement visual field of the alignment system 45. The X axis interferometer 42 detects the position in the X direction of the wafer table WTB on the measurement axis that passes through the center of projection of the projection optical system PL during exposure, and during enhanced global alignment (EGA) measures the position in the X direction of the wafer table WTB on the measurement axis passing through the center of the measurement visual field of the alignment system 45. Moreover, the X axis interferometer 42 measures the position in the X direction of a measurement table MTB using two measurement axes as is appropriate in accordance with baseline measurements and/or the measurement contents of the various measurement instruments provided on the measurement stage MST.

Namely, the X axis interferometer 42 is able to measure the positions in the X direction of the wafer table WTB and/or the measurement table MTB using both the alignment center position and the position of the center of projection in the Y direction. Note that this baseline measurement shows a positional relationship of the wafer stage WST relative to a projection image of a pattern that is projected by the projection optical system PL and, specifically, is the distance between the center of projection of the projection optical system PL and the center of the measurement visual field of the alignment system 45. The Y axis interferometer 44 has a measurement axis that is parallel to the Y axis connecting the center of projection of the projection optical system PL (i.e., the optical axis AX - see FIG. 1) and the center of the measurement visual field of the alignment system 45, and mainly detects the position in the Y direction of the wafer table WTB.

The measurement stage MST has substantially the same structure as the wafer stage WST except for the tube carrier 29 and the six degree-of-freedom pipe (not shown). Namely, as is shown in FIG. 2, the measurement stage MST is provided with a measurement stage main body 46 that is placed on the baseboard 21, and a measurement table MTB that is mounted on the measurement stage main body 46. Moreover, the measurement stage MST is provided with a first drive system 47 that drives the measurement stage main body 46 in a long stroke in the X direction, and that drives the measurement stage main body 46 in micro steps in the Y direction, the Z direction, the θx direction, the θy direction, and the θz direction, and second drive systems 48a and 48b that drive the measurement stage main body 46 and the first drive system 47 in a long stroke in the Y direction. The measurement stage main body 46 is formed by a hollow component which has a rectangular frame-shaped cross section and extends in the X direction.

In the same way as in the first drive system 27 that is provided for the wafer stage WST, the first drive system 47 includes permanent magnets that are provided in pairs for each one of three apertures that are provided on end surfaces in the ±X directions of the measurement stage main body 46, and one Y axis stator and two X axis stators that are provided with a plurality of coils so as to penetrate the measurement stage main body 46 in the X direction via the respective apertures. These permanent magnets and X axis stators and Y axis stator drive the measurement stage main body 46 in a long stroke in the X direction, and in micro steps in the Y direction, and also rotate it in the θz direction. Moreover, the first drive system 47 is provided with permanent magnets that are provided on a bottom surface of the measurement stage main body 46, and with a Z axis stator that generates thrust in cooperation with these permanent magnets. The measurement stage main body 46 can be driven in the Z direction, the θx direction, and the θy direction by these permanent magnets and the Z axis stator. Note that, here, a description is given of an example in which the first drive system 47 is provided with a moving magnet type of linear motor, however, it is also possible for it to be provided with a moving coil type of linear motor.

The second drive systems 48a and 48b include the stators 38a and 38b, and X axis stators and Y axis stators that penetrate the measurement stage main body 46 in the X direction, and also movers 49a and 49b that are fixed to both ends of the Z axis stator that is placed below (i.e., in the -Z direction) the measurement stage main body 46. The movers 49a and 49b are respectively inserted into the internal side of the stators 38a and 38b. The movers 49a and 49b are provided with coils that are aligned in the Y direction, and generate thrust in the Y direction in cooperation with the stators 38a and 38b that are provided with permanent magnets that are aligned in the Y direction. Namely, the second drive systems 48a and 48b are provided with moving coil type linear motors that drive the measurement stage MST in the Y direction. In this manner, in the present embodiment, a structure is employed in which the stators 38a and 38b are shared by a linear motor (i.e., an actuator portion) that drives the wafer stage WST in the Y direction, and a linear motor (i.e., an actuator portion) that drives the measurement stage MST in the Y direction. Note that, here, a description is given of an example in which a moving coil type of linear motor is provided, however, it is also possible for a moving magnet type of linear motor to be provided.

At least a portion of the stage drive section 25 shown in FIG. 3 is constructed by the above described first drive system 27 and second drive systems 28a and 28b that drive the wafer stage WST, and by the first drive system 47 and second drive systems 48a and 48b that drive the measurement stage MST. The various drive mechanisms making up the stage drive section 25 are controlled by the main control apparatus 20 shown in FIG. 3. Namely, the main control apparatus 20, for example, controls movement of the measurement stage MST prior to exposure of a wafer W, and movement of the wafer stage WST during exposure of a wafer W via the stage drive section 25.

The measurement table MTB may be formed from a low thermal expansion material such as, for example, ZERODUR ®, manufactured by Schott Nippon Ltd., and a top surface thereof has liquid repellency (i.e., water repellency). This measurement table MTB is held on the measurement stage main body 46, for example, by vacuum suction, and is constructed such that it is able to be replaced. The height of the surface of the measurement table MTB is set so as to be substantially the same as the height of the surface of the wafer holder 40 that is provided on the wafer table WTB. A reflective surface 51X that is perpendicular to the X direction (i.e., extends in the Y direction) is formed by mirror working on one end in the X direction (i.e., the +X side end) of the measurement table MTB. A reflective surface 51 Y that is perpendicular to the Y direction (i.e., extends in the X direction) is formed in the same way by mirror working on one end in the Y direction (i.e., the -Y side end) of the measurement table MTB.

Interferometric beams (i.e., beams) from the X axis interferometer 42 and the Y axis interferometer 52 that make up the interferometric system 24 (see FIG. 3) are irradiated respectively onto the reflective surfaces 51X and 51Y As a result of the X axis interferometer 42 and the Y axis interferometer 52 receiving reflection light respectively from the reflective surfaces 51X and 51Y, they detect displacement in their measurement directions from reference positions (generally, a fixed mirror is placed on a side surface of the projection unit PU, and/or on a side surface of an off-axis type of alignment system 45 (see FIG. 1 and FIG. 3), and these are used as reference surfaces) of the respective reflective surfaces 51X and 51 Y

Note that instead of a structure in which the reflective surfaces 51X and 51Y are formed on end surfaces of the measurement table MTB, it is also possible to employ a structure in which a Y movable mirror that has a reflective surface (i.e. 51 Y) that extends in the X direction, and an X movable mirror that has a reflective surface (i.e. 51X) that extends in the Y direction are provided respectively on a top surface of the measurement table MTB. In the same way as the Y axis interferometer 44, the above-described Y axis interferometer 52 has a measurement axis that is parallel to the Y axis connecting the center of projection (i.e., the optical axis AX - see FIG. 1) of the projection optical system PL and the center of the measurement visual field of the alignment system 45. The Y axis interferometer 52 detects the position in the Y direction of the measurement table MTB except for when the wafer stage WST is positioned in a loading position (not shown) in order for a wafer W to be replaced.

In addition, the measurement stage MST is provided with a group of measurement instruments in order to perform a variety of exposure-related measurements. This group of measurement instruments may include, for example, a spatial image measurement instrument, a wave front aberration measurement instrument, and an exposure detection instrument and the like. A spatial image measurement instrument measures spatial images that are projected onto the measurement table MTB via the projection optical system PL and water. The wave front aberration measurement instrument disclosed, for example, in PCT International Publication No. WO 99/60361 (corresponding to European Patent No. 1,079,223) can be used for the aforementioned wave front aberration measurement instrument.

The aforementioned exposure detection instrument is a detection instrument that detects information (i.e., light quantity, illumination intensity, illumination intensity unevenness, and the like) relating to the exposure energy of exposure light that is irradiated onto the measurement table MTB via the projection optical system PL, and, for example, the illumination intensity unevenness measurement instrument disclosed in Japanese Patent Application, Publication No. S57-117238 (corresponding to United States Patent No. 4,465,368) and the like, and, for example, the illumination intensity monitor disclosed in Japanese Patent Application, Publication No. H11-16816 (corresponding to United States Patent Application Publication No. 2002/0061469) and the like can be used as such instruments. Note that, in FIG. 3, the above described spatial image measurement instrument, wave front aberration measurement instrument, and exposure detection instrument are shown as a measurement instrument group 63.

A reference plate 53 serving as a measurement pattern portion on which a variety of marks which are used by the measurement instrument group or the alignment system 45 (see FIG. 1 and FIG. 3) are formed is provided at a predetermined position on the top surface of the measurement table MTB. This reference plate 53 is formed from a low thermal expansion material and a top surface thereof has liquid repellency (i.e., water repellency). This reference plate 53 is also able to be replaced on the measurement table MTB.

Returning to FIG 1, the off-axis alignment system 45 that is provided in the holding component that holds the projection unit PU measures the positions of target marks (i.e., alignment marks formed on a wafer W, and reference marks formed on the reference plate 53, and the like). This alignment system 45 is an alignment sensor of an image processing type of field image alignment (FIA) system in which broadband detection light beams that do not photosensitize the resist on the wafer W are irradiated onto the target marks, and an image of the target marks that is formed on a light receiving surface by reflected light from the target marks is picked up using an image pickup element (such as a CCD) together with an image of an index (not shown - this is an index pattern on an index plate provided within the alignment system 45), and these image pickup signals are then output. The image pickup signals from the alignment system 45 are supplied to the main control apparatus 20 shown in FIG. 3.

The exposure apparatus EX of the present embodiment is provided with a maintenance apparatus 55 that carries out maintenance on the measurement stage MST. This maintenance apparatus 55 conducts maintenance, for example, to restore the liquid repellency of the measurement table MTB. Because the exposure apparatus EX of the present embodiment is a liquid immersion type of exposure apparatus, a liquid repellent coating is formed on the top surface of the wafer holder 40 of the wafer stage WST and on the top surface of the measurement table MTB of the measurement stage MST in order to prevent water Lq that is supplied from the liquid supply apparatus 19a (see FIG. 3) via the liquid supply nozzle 18a entering the interiors of the wafer stage WST and the measurement stage MST, and/or in order to make it easy to recover via the recovery nozzle 18b the water Lq supplied through the supply nozzle 18a.

This liquid repellent coating in some cases may undergo a deterioration in liquid repellency due to the irradiation of the illumination light IL (i.e. ultraviolet ray) and, furthermore, there may be a deterioration in the adhesion between the liquid repellent coating and the measurement table MTB due to the irradiation of the illumination light IL and this may lead to peeling. Moreover, because of extended use, there are also times when the liquid repellent coating becomes chemically contaminated so that there is a deterioration in the liquid repellency. There are also cases in which there is a deterioration in the liquid repellency which is caused by organic matter and the like adhering to the liquid repellent coating. If the liquid repellency deteriorates, in some cases watermarks are created on the surface of the liquid repellent coating. Because of this, it is necessary to periodically restore the liquid repellency capability of the liquid repellent coating.

Generally, the maintenance which is performed when the exposure apparatus EX is stopped is performed at either regular or irregular intervals. If the maintenance to restore the liquid repellency capability of the liquid repellent coating is to be performed by stopping the exposure apparatus EX, then the number of occasions on which maintenance is performed is increased causing a reduction in the operating efficiency of the exposure apparatus EX, so that, as a result, there is a possibility that there will be a reduction in throughput. In the present embodiment, the maintenance apparatus 55 that carries out maintenance on the measurement stage MST is provided, and while exposure processing is being performed on a wafer W held on the wafer stage WST, the main control apparatus 20 moves the measurement stage MST to a position adjacent to (i.e., directly beneath) the maintenance apparatus 55, and instructs the maintenance apparatus 55 to perform maintenance on the measurement stage MST.

Furthermore, although not shown in FIG. 1, in the exposure apparatus EX of the present embodiment, a focal point position detection system that is formed by an irradiation system 64a and a light receiving system 64b (see FIG. 3) is provided. This focal point position detection system detects, for example, the position in the Z direction as well as the attitude (i.e., the rotation thereof around the X axis and the Y axis) of a wafer W by irradiating detection light from the irradiation system 64a from an oblique direction onto each of a plurality of detection points on the wafer W, and then receiving the reflected light therefrom using the light receiving system 64b.

Moreover, as a result of the focal point detection system measuring the respective items of information about the position in the Z axis direction of the wafer W at each of the plurality of measurement points, it is possible to detect information on the tilt (i.e., the rotation angle) in the θX and θY directions of the wafer W. However, it is also possible for at least a portion of this plurality of measurement points to be set within the liquid immersion area (or projection area), or for all of the plurality of measurement points to be set outside the liquid immersion area. Furthermore, when it is possible, for example, for the interferometers 42 and 44 to measure information on the position in the Z axis direction, the θX direction, and the θY direction of the wafer W (i.e., the wafer stage WST), then it is also possible for the focal point position detection system to not be provided in order to allow information on the position in the Z axis direction of the wafer W to be measured during the operation to expose the wafer W, and it is possible to control the position of the wafer W in the Z axis direction, the X direction, and the Y direction using at least the results from measurements by the interferometers 42 and 44 during an exposure operation.

FIG. 3 is a block diagram showing the structure of the control system of the exposure apparatus EX. The structure of the control system shown in FIG. 3 is centered on the main control apparatus 20 which is formed by a microcomputer (or workstation) that performs supervisory control of the overall operations of the exposure apparatus EX. Memory 65 and a display 66 such as a cathode ray tube (CRT) display (or a liquid crystal display) are connected to the main control apparatus 20. The memory 65 stores information necessary for controlling operations of the exposure apparatus EX, for example, baseline measurements, shot layouts obtained by performing EGA calculations, exposure amount history and the like. The display 66 displays a variety of information such as information showing the device state of the exposure apparatus EX and error information and the like that is output from the main control apparatus 20.

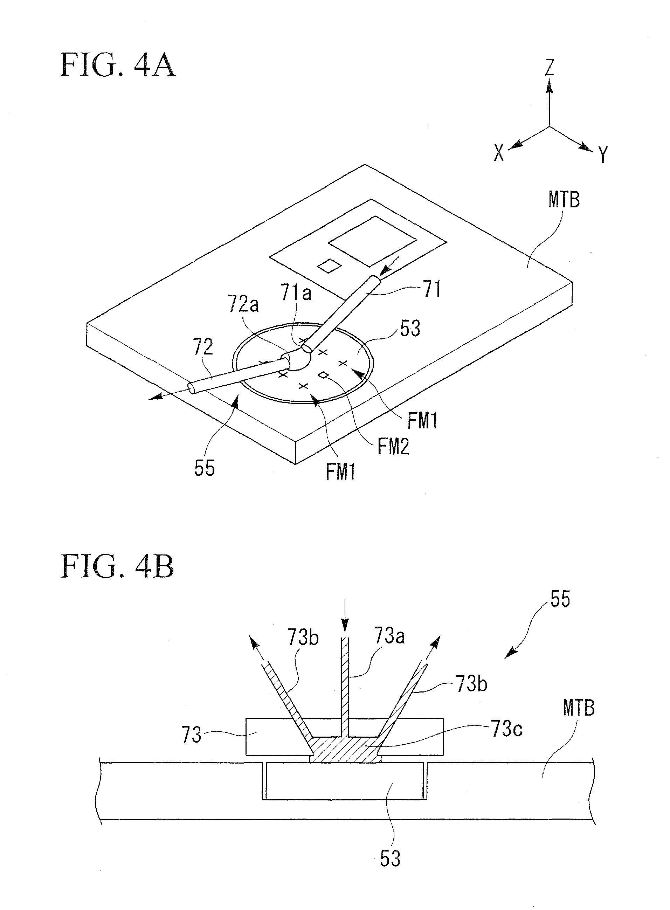

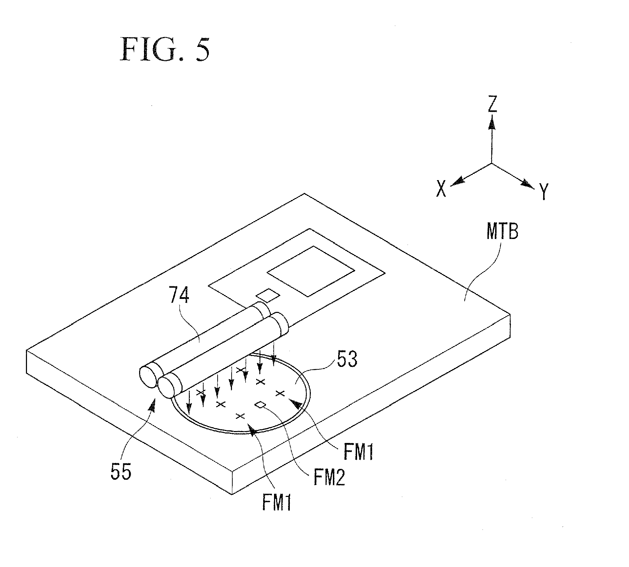

Next, the maintenance apparatus 55 will be described. FIGS. 4A and 4B and FIG. 5 show an example of the structure of the maintenance apparatus 55. Note that in these drawings, the same symbols are allocated to components that are the same as those in FIG. 1 and FIG. 2. The maintenance apparatus 55 shown in FIGS. 4A and 4B and FIG. 5 washes (i.e. cleans) the surface of the measurement table MTB on the measurement stage MST, and maintains the liquid repellency of the liquid repellent coating (i.e., the water repellent coating) on the measurement table MTB. The maintenance apparatus 55 shown in FIGS. 4A and 4B cleans the surface of the measurement table MTB using a cleaning agent, while the maintenance apparatus 55 shown in FIG. 5 cleans by photochemical-cleaning.

The maintenance apparatus 55 shown in FIGS. 4A and 4B performs localized cleaning of the surface of the measurement table MTB. Alcohols such as methanol or ethanol or the like, or hydrogen peroxide (H₂O₂) can be used as the cleaning agent used by the maintenance apparatus 55 shown in FIGS. 4A and 4B.

The maintenance apparatus 55 shown in FIG. 4A is provided with cleaning nozzles 71 and 72. One end 71a and one end 72a of the respective cleaning nozzles 71 and 72 are placed such that they can move adjacent to the surface of the measurement table MTB, and are also placed facing each other. Another end of the cleaning nozzle 71 is connected to a cleaning agent supply apparatus (not shown) that supplies cleaning agent (i.e., cleaning solution), while another end of the cleaning nozzle 72 is connected to a cleaning agent recovery apparatus (not shown) that recovers cleaning agent that has been supplied to the measurement table MTB. Note that the cleaning agent supply apparatus and the cleaning agent recovery apparatus that are not shown in the drawings form part of the maintenance apparatus 55, and operations thereof are controlled by the main control apparatus 20 shown in FIG. 3. The cleaning nozzles 71 and 72 may be provided at a position above the measurement table MTB when the measurement stage MST has been moved to a predetermined standby position during an exposure of a wafer W held on the wafer stage WST, or they may be permanently provided on the measurement stage MST.

In the example shown in FIG. 4A, a state is depicted in which the one ends 71 a and 72a of the cleaning nozzles 71 and 72 are placed above the reference plate 53. In this state, if the main control apparatus 20 controls the cleaning agent supply apparatus and the cleaning agent recovery apparatus (not shown) that are provided in the maintenance apparatus 55, and the cleaning agent that is supplied onto the reference plate 53 from the one end (i.e., a supply aperture) 71a of the cleaning nozzle 71 is immediately recovered by the one end (i.e., a recovery aperture) 72a of the cleaning nozzle 72, then localized cleaning of the reference plate 53 can be achieved. By moving the measurement stage MST relative to the cleaning nozzles 71 and 72, localized cleaning (i.e., spot cleaning) of a desired portion of the measurement table MTB can be achieved. Moreover, if the measurement stage MST is moved while supply of the cleaning agent from the cleaning nozzle 71 is being executed and while recovery of the cleaning agent from the cleaning nozzle 72 is being executed, then a desired area (for example, an area extending in a straight line) of the measurement table MTB can be cleaned.

Here, a simple description of the reference plate 53 will be given. The reference plate 53 has a circular configuration, and reference marks (referred to below as 'second reference marks') FM2 that are measured by the alignment system 45 when the aforementioned first reference marks (referred to below as the 'first reference marks FM1') and the baseline amounts are being measured are formed on the top surface of the reference plate 53. The reason for making the reference plate 53 circular is to make it easier to adjust the angle of the reference plate 53 within the plane of the measurement table MTB, and to prevent as far as possible the water which is supplied to the top surface of the management table MTB entering the interiors of the measurement table MTB and the measurement stage MST.

The first reference marks FM1 are formed by cruciform apertures (i.e. slits) in a light-shielded area that is formed from a metal such as chromium (Cr). The second reference marks FM2 are made up of X marks that are formed by spacing at predetermined intervals in the X direction mark groups in which mark elements whose longitudinal direction extends in the Y direction are arranged at predetermined intervals in the X direction, and Y marks that are formed by spacing at predetermined intervals in the Y direction mark groups in which mark elements whose longitudinal direction extends in the X direction are arranged at predetermined intervals in the Y direction. Note that the respective mark elements of the second reference marks FM2 may be formed from a metal such as chromium (Cr), or the respective mark elements may be formed by forming apertures (i.e., slits) in a light-shielded area that is formed from a metal such as chromium (Cr).

The maintenance apparatus 55 shown in FIG. 4B is provided with a cleaning plate 73. This cleaning plate 73 is positioned such that a bottom surface thereof is substantially parallel with the surface of the measurement table MTB. One supply tube 73a that is connected to a cleaning agent supply apparatus (not shown) that supplies cleaning agent, and two recovery tubes 73b that are connected to a cleaning agent recovery apparatus (not shown) that recovers cleaning agent supplied to the measurement table MTB are provided in the cleaning plate 73. In addition, a hole portion (i.e., a recessed portion) 73c that is in communication with the supply tube 73a and the recovery tubes 73b and in which a predetermined quantity of cleaning agent is held is formed in a center portion of a bottom surface of the cleaning plate 73.

Note that, in the same way as in the case in FIG. 4A, the cleaning agent supply apparatus and the cleaning agent recovery apparatus that are not shown in the drawings form part of the maintenance apparatus 55, and operations thereof are controlled by the main control apparatus 20 shown in FIG. 3. Moreover, the cleaning plate 73 may be provided at a position above the measurement table MTB when the measurement stage MST has been moved to a predetermined standby position, or may be permanently provided on the measurement stage MST.

In FIG. 4B, a state is depicted in which the cleaning plate 73 is placed above the reference plate 53. In this state, if the main control apparatus 20 controls the cleaning agent supply apparatus and the cleaning agent recovery apparatus (not shown) that are provided in the maintenance apparatus 55, so that cleaning agent is supplied from the supply tube 73a onto the reference plate 53, and the supplied cleaning agent is recovered through the recovery tube 73b, then a fixed quantity of cleaning agent is held in the hole portion 73c and cleaning agent can be supplied to a predetermined surface area of the reference plate 53. As a result, the surface area of the reference plate 53 can be cleaned. Note that the cleaning agent held in the hole portion 73c is constantly being replaced. In this state, if the measurement stage MST is moved, then it is possible to clean a desired portion of the measurement table MTB over a wide surface area. Note that in FIG. 4A and FIG. 4B, the top surface (for example, the reference plate 53) of the measurement table MTB is cleaned using a cleaning agent (i.e., a cleaning solution), however, it is also possible to clean the top surface of the measurement table MTB using the liquid (which is water in the case of the present embodiment) that is used in the liquid immersion exposure.

The maintenance apparatus 55 shown in FIG. 5 cleans the surface of the measurement table MTB on the measurement stage MST by photochemical-cleaning, and maintains the liquid repellency of the liquid repellent coating on the measurement table MTB. This maintenance apparatus 55 is provided with an ultraviolet ray lamp 74 that emits ultraviolet light having a longer wavelength than that of the illumination light IL (for example, approximately 230 to 400 nm). This ultraviolet ray lamp 74 is positioned above the measurement table MTB. Note that the ultraviolet ray lamp 74 may be provided at a position above the measurement table MTB when the measurement stage MST has been moved to a predetermined standby position, or may be permanently positioned on the measurement stage MST. By irradiating ultraviolet light onto the measurement table MTB using this ultraviolet ray lamp 74, it is possible to scatter (i.e., decompose and remove) organic matter adhering to the liquid repellent coating. This results in the surface of the liquid repellent coating being cleaned, and consequently enables the liquid repellency of the liquid repellent coating to be improved. In this case, it is desirable for experiments and/or simulations to be performed in order for the wavelength and intensity of the cleaning light as well as the irradiation time thereof to be optimized in order that the liquid repellency capabilities of the liquid repellent coating are not deteriorated by the irradiation of the cleaning light from the ultraviolet ray lamp 74. Note that it is also possible for a combination of the above described cleaning using a cleaning agent and cleaning using cleaning light to be performed.

It is also possible to construct the maintenance apparatus 55 such that it is provided with a mechanism for peeling off and then recoating (i.e., for performing maintenance on) the liquid repellent coating on the measurement table MTB. By regenerating the liquid repellent coating on the measurement table MTB at regular intervals using such a structure, the liquid repellency of the surface of the measurement table MTB is maintained. By cleaning the surface of the measurement table MTB using the above-described maintenance apparatus 55, or by peeling off and then recoating the liquid repellent coating, a high level of liquid repellency can be constantly maintained on the surface of the measurement table MTB. As a result, the various measurement components mounted on the measurement stage MST can be kept clean, and it is possible to prevent any deterioration in the accuracy of measurements made using these instruments. As a result, accurate exposure becomes possible.

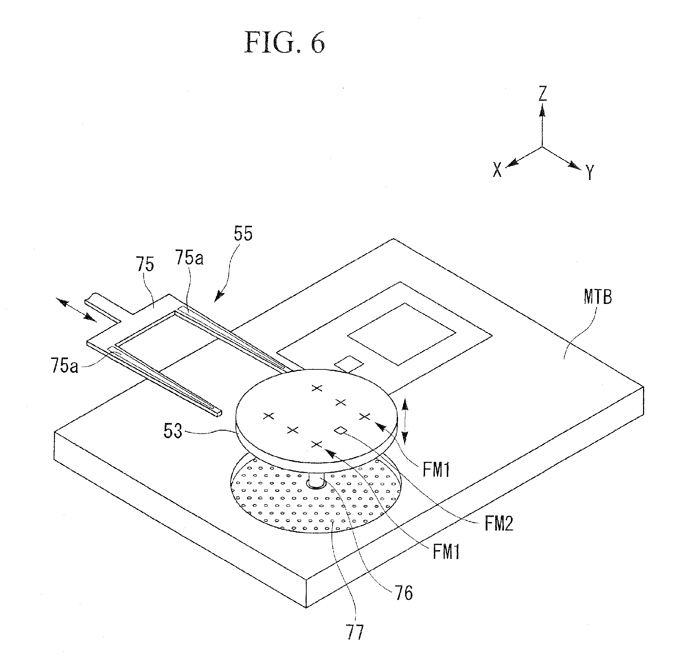

The measurement apparatus 55 described using FIGS. 4A and 4B and FIG. 5 maintains the liquid repellency of the measurement table MTB by cleaning the surface of the measurement table MTB, however, it is also possible to provide a maintenance apparatus 55 that maintains the liquid repellency of the measurement table MTB by replacing an entire measurement table MTB whose liquid repellency has deteriorated or a portion thereof with a measurement table having a high level of liquid repellency. FIG. 6 is a perspective view showing another structural example of a maintenance apparatus 55. The maintenance apparatus 55 shown in FIG. 6 is provided with a replacement function to replace the reference plate 53 provided in the measurement table MTB.

The maintenance apparatus 55 shown in FIG. 6 is provided with a replacement function to replace the reference plate 53 in the form of a transporting arm 75. This transporting arm 75 is constructed so as to be able to hold the reference plate 53 and move in the Y direction, and suctioning portions 75a that hold the reference plate 53 by vacuum suction or the like are provided on a top surface thereof. Moreover, as is shown in FIG. 6, a lifting/lowering mechanism 76 which lifts or lowers the reference plate 53 relative to the measurement table MTB in the Z direction is provided on the measurement stage MST. The transporting arm 75 and the lifting/lowering mechanism 76 are controlled by the main control apparatus 20 shown in FIG. 3. In addition, as is shown in FIG. 6, a number of suction holes 77 are formed in the measurement table MTB. The reference plate 53 is held on the measurement table MTB by being vacuum suctioned by these suction holes 77.

Replacing a reference plate 53 is performed via the following procedure under the control of the main control apparatus 20. Namely, firstly the suctioning of the reference plate 53 by the suction holes 77 is terminated, and the lifting/lowering mechanism 76 is driven so as to lift the reference plate 53 upwards (i.e., in the +Z direction). Next, the transporting arm 75 is moved in the +Y direction so that the transporting arm 75 is placed below (i.e., in the -Z direction) the reference plate 53. By then lowering the transporting arm 75 in this state, the reference plate 53 is transferred from the raising/lowering mechanism 76 to the transporting arm 75. When this transferring of the reference plate 53 has ended, the transporting arm 75 is moved in the - Y direction, and the transported reference plate 53 is stored in a stocker (not shown). In addition, a new reference plate is withdrawn from the stocker and held on the transporting arm 75.

Next, the transporting arm 75 is moved in the +Y direction and a new reference plate is placed above the portion where the plurality of suctioning portions 75a are formed. If, in this state, the lifting/lowering mechanism 76 is driven so as to be lifted upwards (i.e., in the +Z direction), then the new reference plate is transferred from the transporting arm 75 to the lifting/lowering mechanism 76. After this, if the transporting arm 75 is moved in the -Y direction and the transporting arm 75 is placed on standby below the reference plate 53, and if the lifting/lowering mechanism 76 is then lowered and the reference plate is suction via the suctioning holes 77, then the new reference plate 53 is held on the measurement table MTB. By replacing the reference plate 53 using the above-described maintenance apparatus 55, it is possible to prevent any deterioration in the liquid repellency of the reference plate 53 to which water Lq is frequently supplied each time a measurement is made. Note the maintenance apparatus 55 shown in FIG. 6 is an apparatus that replaces a reference plate 53 that is a portion of the measurement table MTB, however, it may also be an apparatus that replaces the entire measurement table MTB. Note also that it is possible for not only the reference plate 53 to be replaced, but to also make it possible to replace components of the various measurement devices which come into contact with liquid, such as the spatial image measurement instrument, the wave front aberration measurement instrument, and the exposure detection instrument and the like that are provided on the measurement stage MST.

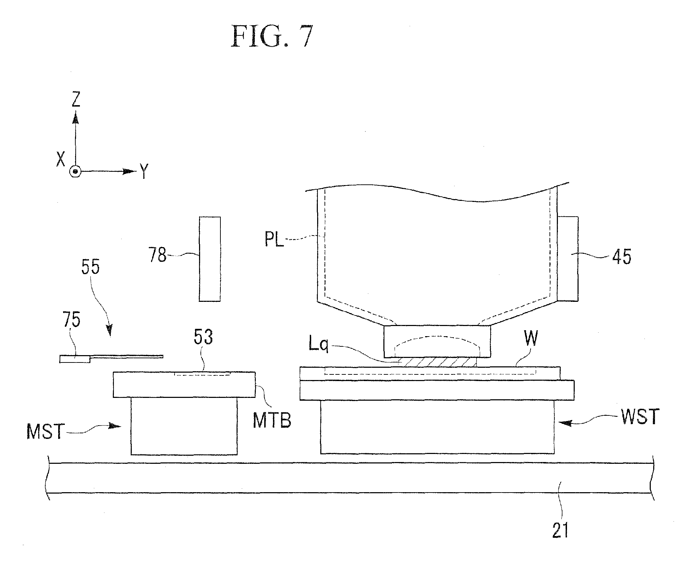

Note that the reference plate 53 is a component which provides a reference when the various measurements which are performed by the exposure apparatus EX are being performed. Because of this, it is necessary for it to be held with a high degree of accuracy at a predetermined position on the measurement table MTB. If replacement of the reference plate 53 is performed by the above described maintenance apparatus 55 shown in FIG. 6, there is a possibility of the newly held reference plate 53 being held in an incorrectly positioned state. Because of this, it is desirable for a position measurement device that measures the position of the reference plate 53 to be provided. FIG. 7 is a side view showing a position measurement device that is provided in the maintenance apparatus 55 shown in FIG. 6.

As is shown in FIG. 7, a position measurement device 78 that measures the position of the reference marks (i.e., the first reference marks FM1 or the second reference marks FM2) that are formed on the reference plate 53 on the measurement stage MST is provided separately from the alignment system 45 in the -Y direction of the projection optical system PL. Note that it is desirable for the position measurement device 78 to be placed on a straight line extending in the Y direction and intersecting the optical axis of the projection optical system PL and the optical axis of the alignment system 45, however, it can be installed in any desired position provided that this position allows the position of the reference marks to be measured.

Measurement results from the position measurement device 78 are output to the main control apparatus 20 (see FIG. 3). Based on these measurement results, the main control apparatus 20 corrects the measurement results from the alignment system 45. Namely, if there is an error in the position of the reference plate 53 that is caused by the replacement of the reference plate 53, or if there is a manufacturing error in the replaced reference plate 53, these errors appear as measurement errors when the reference plate 53 is measured by the alignment system 45. Because of this, by measuring in advance errors in the position of the reference plate 53 using the position measurement device 78, and correcting the measurement results from the alignment system 45 using the measurement results from the position measurement device 78, any effects caused by positional errors of the reference plate 53 can be eliminated.

The measurement of the reference plate 53 by the position measurement device 78 is performed either at regular intervals or when the reference plate 53 is measured. By performing this position measurement, highly accurate measurements can be made by the alignment system 45. Note that, here, a case in which the main control apparatus 20 corrects the measurement results from the alignment system 45 using measurement results from the position measurement device 78 is given as an example, however, it is also possible to adjust the position of the reference plate 53 by providing a mechanism that adjusts the position of the reference plate 53 based on measurement results from the position measurement device 78.

As has been described above, maintenance that is performed by the maintenance apparatus 55 shown in FIG. 4A through FIG. 7 is performed during exposure processing to expose a wafer W on the wafer stage WST. Because of this, there is no longer any necessity to halt the exposure apparatus EX at regular or irregular intervals and perform maintenance on the measurement stage MST in order to maintain liquid repellency (i.e., in order to restore liquid repellency). Consequently, the operating efficiency of the exposure apparatus can be improved. As a result, a further improvement in throughput can be achieved.

Next, a description will be given of operations of the exposure apparatus EX which has the above described structure. Note that, during the operations described below, control to open and close the respective valves of the liquid supply apparatus 19a and the liquid recovery apparatus 19b of the liquid immersion apparatus 17 is performed in the manner described above by the main control apparatus 20 so that the portion directly below the front lens GL of the projection optical system PL is constantly full of water. However, in the description below, in order to simplify the description, no description is given relating to this control of the liquid supply apparatus 19a and the liquid recovery apparatus 19b.

When the exposure of a wafer W on the wafer stage WST is performed, the wafer stage WST is placed below (i.e., in the -Z direction) the projection optical system PL, and the measurement stage MST is placed on standby at a predetermined standby position in the -Y direction where it does not collide with (i.e., make contact with) the wafer stage WST. An exposure operation on a wafer W is performed, based on results from a wafer alignment such as, for example, an enhanced global alignment (EGA) or the like that has been performed in advance and based on the latest measurement results of the baseline amount by the alignment system 45, by the main control apparatus 20 repeatedly performing an shot-to-shot movement operation in which the wafer stage WST is moved to a scan start position (i.e., an acceleration start position) in order to expose each shot area on the wafer W, and a scan exposure operation in which a pattern formed on the reticle R is transferred onto each shot area using a scan exposure method.

In addition to the wafer alignment, focal point position detection is also performed for the wafer W using a focal point position detection system (not shown) that is formed by the irradiation system 64a and the light receiving system 64b, so that the surface of the wafer W is positioned at the focal point position of the projection optical system PL. The detection of the focal point position for the wafer W, namely, the position where detection light is irradiated from the irradiation system 64a onto the wafer is set to a position that is not filled by the water Lq. Focal point position detection is performed for a shot area (i.e., a first shot area) where the exposure processing is to be performed initially at a position before this shot area is immersed with the water Lq. In addition, the irradiation of detection light from the irradiation system 64a is continued even while the exposure processing is being performed on this first shot area, so that focal point position information is collected about the shot area where the detection light is irradiated. Next, when the exposure processing of the first shot area is ended and the exposure processing is to be implemented for the next shot area (i.e., the second shot area), the surface of the second shot area is positioned at the focal point position of the projection optical system PL using the focal point position information that was collected while the exposure processing was being performed for the first shot area. In this manner, the second and subsequent shot areas are positioned at the focal point position of the projection optical system PL using the focal point position information that was detected and collected during the exposure processing of the previous shot area. On other words, because there is no need to provide a separate focal point position information detection step, it is possible to improve throughput.

Here, the above-described moving of the wafer stage WST is performed by the main control apparatus 20 controlling the driving of the first drive system 27 and the second drive systems 28a and 28b, while the main control apparatus 20 monitors detection values from the X axis interferometer 42 and the Y axis interferometer 44. Moreover, the above-described scan exposure is performed by the main control apparatus 20 controlling the driving of the reticle stage drive section 11 as well as the first drive system 27 and the second drive systems 28a and 28b, while the main control apparatus 20 is monitoring detection values from the X axis interferometer 42, the Y axis interferometer 44, and the reticle interferometer 12, and is achieved by the main control apparatus 20 scanning the reticle R (i.e., the reticle stage RST) and the wafer W (i.e., the wafer stage WST) relatively in the Y direction, and, during the uniform movement between the point during this scanning when the acceleration has ended and a point immediately prior to the start of deceleration, causing the reticle R (i.e., the reticle stage RST) and the wafer W (i.e., the wafer stage WST) to perform a uniform synchronous movement in the Y direction in the illumination area of the illumination light IL. Note that the above-described scan operation is performed in a state in which water is held between the front lens GL and the wafer W.

While the above exposure processing is being performed, the surface of the measurement table MTB of the measurement stage MST which is on standby at a predetermined standby position is washed (i.e., undergoes cleaning) by the maintenance apparatus 55 shown in FIGS. 4A and 4B and FIG. 5. Alternatively, peeling off and subsequent recoating (i.e., maintenance) of the liquid repellent coating on the surface of the measurement table MTB is performed. Moreover, the reference plate 53 that is provided on the measurement table MTB is replaced by the maintenance apparatus 55 shown in FIG. 6 or FIG. 7. Note that when the surface of the measurement table MTB is cleaned by photochemical action with the maintenance apparatus 55 shown in FIG. 5, it is desirable that the measurement stage MST is optically shielded from the wafer stage WST by a light shielding plate or the like in order to prevent ultraviolet light from the ultraviolet ray lamp 74 being irradiated onto the wafer W.

Note that it is not necessary for the maintenance apparatus 55 to be provided with all of the above-described maintenance functions described using FIG. 4A through FIG. 7, and it is sufficient if it is provided with at least one of these functions. Moreover, when the maintenance apparatus 55 is provided with a plurality of maintenance functions, it is possible during the exposure processing of a single wafer for a plurality of maintenance functions to be used or for just one maintenance function to be used.

When the exposure of a wafer W held on the wafer stage WST is ended, the main control apparatus 20 controls the driving of the first drive system 47 and the second drive systems 48a and 48b that are provided on the measurement stage MST based on detection values from the Y axis interferometer 52, and causes the +Y side surface of the measurement stage MST (i.e., the measurement table MTB) to come into contact with the -Y side surface of the wafer stage WST. Note that, here, the description uses as an example a case in which the +Y side surface of the measurement table MTB is brought into contact with the -Y side surface of the wafer holder (i.e., the auxiliary plate), however, it is also possible for the main control apparatus 20 to hold the measurement table MTB and the wafer table WTB in a non-contact state at a distance of, for example, approximately 300 µm (i.e., a gap that does not allow the water to leak because of surface tension) in the Y direction while monitoring the measurement values from the interferometers 44 and 52.

Next, the main control apparatus 20 commences operations to drive the two stages WST and MST in the +Y direction while maintaining the positional relationship in the Y direction between the wafer table WTB and the measurement table MTB. When the wafer stage WST and the measurement stage MST are driven simultaneously by the main control apparatus 20 in this manner, in conjunction with the movement of the wafer stage WST and the measurement stage MST in the +Y direction, the water Lq that is held between the wafer W and the front lens GL that is provided in the projection unit PU moves in sequence over the wafer W, the wafer holder 40, and the measurement table MTB. Note that during this movement, the wafer table WTB and the measurement table MTB maintain a positional relationship whereby they are in mutual contact.

If the wafer stage WST and the measurement stage MST are further simultaneously driven a predetermined distance in the +Y direction, the water remains held between the measurement stage MST and the front lens GL. Next, the main control apparatus 20 controls the driving of the first drive system 27 and the second drive systems 28a and 28b which are provided on the wafer stage WST while controlling the position of the wafer stage WST based on detection values from the X axis interferometer 43 and the Y axis interferometer 44a, and moves the wafer stage to a predetermined loading position and also exchanges the wafer with the first wafer of the next lot. Concurrent with this, the main control apparatus 20 executes when necessary predetermined measurements using the measurement stage MST. An example of these measurements includes baseline measurements by the alignment system 45 performed after the reticle exchange on the reticle stage RST.

When the above-described exchanging of the wafer W on the wafer stage WST and the measurements using the measurement stage MST are ended, the main control apparatus 20 places the measurement stage MST and the wafer stage WST in mutual contact and, while maintaining this state of contact, drives them within an XY plane such that the wafer stage WST is returned to directly beneath the projection unit PU. Next, on the wafer stage WST side, wafer alignment of the wafer W after the exchange, namely, detection of the alignment marks on the wafer W by the alignment system 45 after the exchange is performed. EGA calculations are then made, and positional coordinates of a plurality of shot areas on the wafer W are calculated.

Next, conversely to the previous operation, the main control apparatus 20 simultaneously drives the wafer stage WST and the measurement stage MST in the -Y direction while maintaining the positional relationship in the Y direction between the wafer stage WST and the measurement stage MST. After the wafer stage WST (i.e., the wafer W) has been moved to beneath the projection optical system PL, the measurement stage MST is withdrawn to a predetermined position. In the same way as is described above, the main control apparatus 20 then executes a step-and-scan type of exposure operation on the new wafer W, and sequentially transfers a reticle pattern onto the plurality of shot areas on the wafer.

Note that in the above description, during the wafer exposure processing, maintenance is performed on the measurement stage MST (i.e., the measurement table MTB) using the maintenance apparatus 55, however, it is also it possible to perform maintenance operations using the maintenance apparatus 55 when exposure processing is not being performed on a wafer. In this case, it is possible to perform not only maintenance on the measurement stage MST (i.e., the measurement table MTB), but to also perform maintenance on the wafer stage WST (for example, cleaning the top surface of the wafer stage WST). Note that if maintenance is performed on the wafer stage WST, then it is desirable for a dummy substrate to be mounted on the wafer stage WST for maintenance purposes instead of a wafer.

The exposure apparatus EX shown in FIG 1 is placed within a temperature controlled chamber (not shown), however, there is a tendency for air to remain motionless in the space between the measurement stage MST and the wafer stage WST, and it may be considered that there is a possibility of a temperature change being generated by the heat that is emitted from heat generating sources such as the linear motor provided in the wafer stage WST or the measurement stage MST. Because of this, in the exposure apparatus EX of the present embodiment, a temperature control apparatus is provided in the measurement stage MST that controls the temperature of at least one of the measurement stage MST and the wafer stage WST by controlling the flow of a gas (i.e., air) in the space between the measurement stage MST and the wafer stage WST.

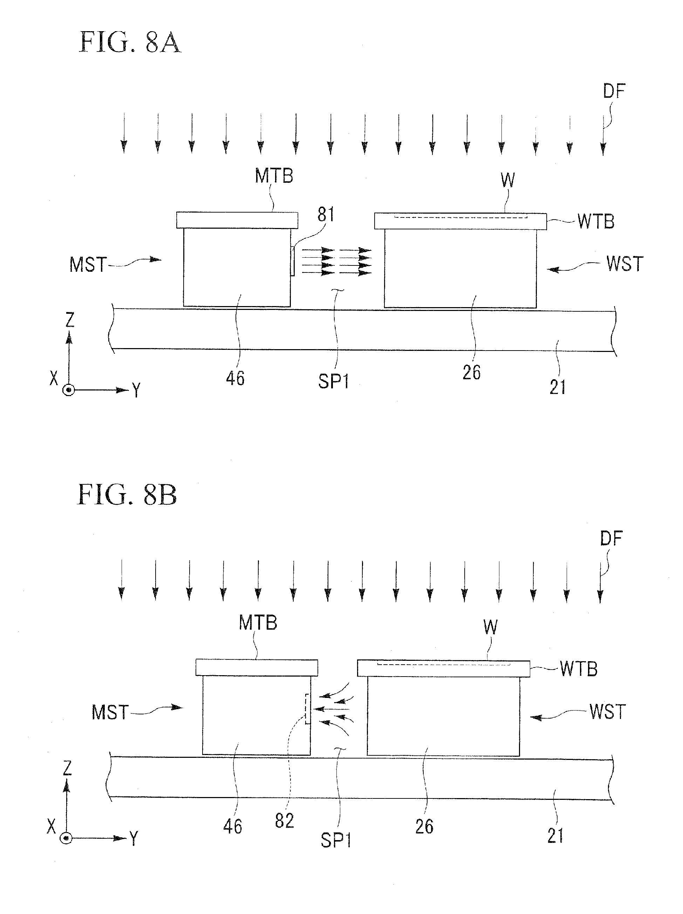

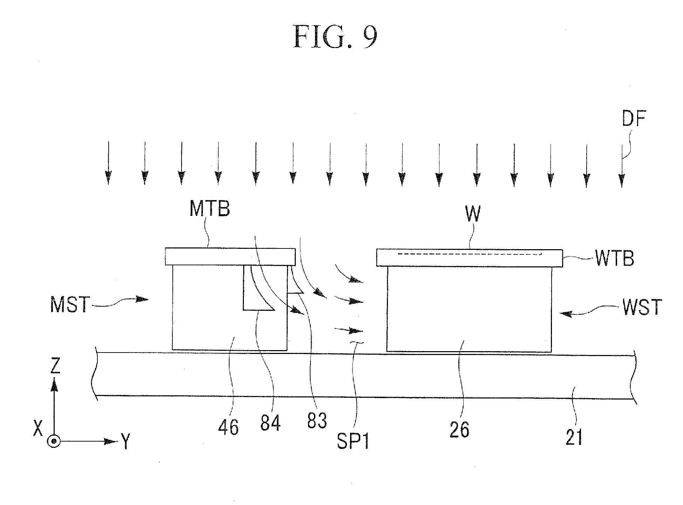

FIGS. 8A and 8B and FIG. 9 show a temperature control apparatus provided in the measurement stage MST. Note that, as is shown in FIGS. 8A and 8B and FIG. 9, in the exposure apparatus of the present embodiment, an air-conditioning apparatus (not shown) is provided inside a chamber (not shown) that generates a downward flow of air (referred to below as a down flow) DF by supplying a gas (i.e., air) that has been adjusted to a predetermined temperature in a downward direction (i.e., the -Z direction). This down flow DF makes it possible to reduce detection errors, for example, from the interferometers 52 and 44 shown in FIG. 1, and keeps the temperatures of the wafer stage WST and the measurement stage MST at predetermined temperatures.

In the example shown in FIG. 8A, a temperature control apparatus 81 that supplies a gas that has been adjusted to a predetermined temperature in the direction of the wafer stage WST is provided on the +Y surface of the measurement stage main body 46. As is shown in FIGS. 8A and 8B, in the case of the wafer stage WST, because the surface area occupied by the wafer table WTB within an XY plane is greater than that occupied by the wafer stage main body 26, the down flow DF is obstructed by the wafer table WTB and there is a possibility that it will not be able to flow properly around the wafer stage main body 26. The same is true in the case of the measurement stage MST, i.e., that the down flow DF will be obstructed by the measurement table MTB and there is a possibility that it will not be able to flow properly around the measurement stage main body 46. In this case, there is a possibility that the flow of gas in a space SP1 between the measurement stage MST and the wafer stage WST will become stagnant so that, as a result, there is a possibility that a temperature change will be generated in the measurement stage MST and the wafer stage WST.

Because the temperature control apparatus 81 is provided in the measurement stage MST so that temperature controlled gas is supplied in the direction of the wafer stage WST, temperature controlled gas is also supplied to the portion between the measurement stage MST and the wafer stage WST where the down flow DF is obstructed. Accordingly, it is possible to control the temperatures of both the measurement stage MST and the wafer stage WST.

In the example shown in FIG. 8B, an exhaust duct 82 is provided on the +Y side surface of the measurement stage main body 46. The gas in the space SP1 between the measurement stage MST and the wafer stage WST is suctioned by this exhaust duct 82 and, as a replacement, temperature controlled gas (for example, the down flow DF) flows into the space SP1. Accordingly, any stagnant air in the space SP1 between the measurement stage MST and the wafer stage WST is eliminated and, as a result, it is possible to control the temperatures of both the measurement stage MST and the wafer stage WST.

In the example shown in FIG. 9, baffle plates 83 and 84 are provided that change the direction of the down flow DF towards the wafer stage WST. The baffle plate 83 is mounted on the +Y side surface of the measurement stage main body 46, while a baffle 84 is mounted on the +X side surface and on the -X side surface (this latter is not shown) of the measurement stage main body 46. Note that these baffle plates 83 and 84 are each mounted such that they do not obstruct the above described contact between the measurement stage MST (i.e., the measurement table MTB) and the wafer stage WST. As is shown in FIG. 9, the direction of the down flow DF is changed towards the wafer stage WST by the baffle plates 83 and 84 so that any stagnant air in the space SP1 between the measurement stage MST and the wafer stage WST is eliminated and, as a result, it is possible to control the temperatures of both the measurement stage MST and the wafer stage WST.

By providing the above described temperature control apparatus, it is possible in the case of the measurement stage MST to improve the measurement accuracy of the various measurement instruments, while it is possible in the case of the wafer stage WST to prevent any deterioration in the exposure accuracy that is due to expansion of the wafer stage WST or the like.

Embodiments of the present invention has been described above, however the present invention is not limited to the above-described embodiments and may also be used in an exposure apparatus which does not employ a liquid immersion method. Moreover, in the above-described embodiments, the description uses as an example a case in which ArF excimer laser light is used, however, apart from this it is also possible to use, for example, g-rays (having a wavelength of 436 nm), i-rays (having a wavelength of 365 nm), or KrF excimer laser light (having a wavelength of 248 nm), F₂ laser light (having a wavelength of 157 nm), Kr₂ laser light (having a wavelength of 146 nm), YAG laser light (having a wavelength of 436 nm), or high frequency waves from a semiconductor laser. Furthermore, higher harmonics may be used by employing a fiber amplifier, which is doped by, for example, erbium (Er) (or both erbium and ytterbium (Yb)), to amplify a single wavelength laser, in the infrared region or the visible region, excited by a DFB (distributed feedback) semiconductor laser or a fiber laser, and then to convert the wavelength to ultraviolet light using a nonlinear optical crystal. For example, if the emission wavelength of the single wavelength laser is taken as being within a range of 1.51 to 1.59 µm, then magnification 8 higher harmonics whose generated wavelength is within a range of 189 to 199 nm, or magnification 10 higher harmonics whose generated wavelength is within a range of 151 to 159 nm are output.

Note that in the above described embodiments, various positional information is measured concerning the reticle stage RST and the wafer stage WST using an interferometric system (24), however, the present invention is not limited to this and it is also possible to use, for example, an encoder system that detects scales (i.e., diffraction gratings) provided on the respective stages. In this case, it is preferable to form a hybrid system that is provided with both an interferometric system and an encoder system, and to perform calibration on the measurement results from the encoder system using measurement values from the interferometric system. It is also possible to switch between the interferometric system and the encoder system, or to use both systems and control the stage positions.

Moreover, the present invention can also be applied to a twin stage type of exposure apparatus that is provided with a plurality of wafer stages. The structure as well as the exposure operation of a twin stage type of exposure apparatus is disclosed, for example, in Japanese Patent Application, Publication Nos. H10-163099 and H10-214783 (corresponding to United States Patent Nos. 6,341,007, 6,400,441, 6,549,269, and 6,590,634), Published Japanese Translation No. 2000-505958 of the PCT International Application (corresponding to United States Patent No. 5,969,441), and United States Patent No. 6,208,407. In the case of a twin stage type of exposure apparatus, it is possible, for example, while exposure processing is being performed on a wafer held on one stage to perform maintenance on the other stage. It is also possible to perform the maintenance on the two stages alternatively.

Furthermore, the present invention may also be applied to the wafer stage described in Japanese Patent Application No. 2004-168481 (corresponding to PCT International Publication No. WO 2005/122242) previously filed by the applicants of the present application.

Moreover, in the above described exposure apparatus, a liquid immersion area is formed on the substrate to be exposed, and exposure of the substrate is conducted via a liquid, however, it is also possible for the present invention to also be applied to what are known as 'dry exposure apparatuses' in which a substrate is exposed without using a liquid.

In the projection optical system PL, both the substance surface (i.e., the reticle R) side and the image plane (i.e.,. the wafer W) side are telecentric, however, it is also possible for only one to be telecentric. Moreover, the system is not limited to only being a reduction system that projects a reduced image of the pattern image on the mask M, and may also be a system that projects a magnified image. Furthermore, as the projection optical system PL, it is possible to use a reflective system that is composed solely of reflective optical elements, or a catadioptric system having both reflective optical elements and refractive optical elements. Note that, for example, quartz or fluorite may be used for the glass material forming the plurality of lens elements that are provided in the projection optical system PL in accordance with wavelength of the illumination light IL.

Note also that not only a semiconductor wafer that is used to manufacture a semiconductor device, but a glass substrate that is used for a display device, a ceramic wafer that is used for a thin-film magnetic head, or the original plate (i.e., synthetic quartz or a silicon wafer) of a mask or reticle used in an exposure apparatus, or the like may also be used as the substrate that is held on the movable stage in each of the above described embodiments. As the exposure apparatus EX, a scan exposure apparatus that does not employ a liquid immersion method, or a step-and-repeat type of projection exposure apparatus (i.e., a stepper) that collectively exposes the pattern on the reticle R with the reticle R and the wafer W in a stationary state, and then moves the wafer W in successive steps can also be used. Moreover, the present invention may also be applied to a step-and-stitch type of exposure apparatus that partially overlaps and transfers at least two patterns on a wafer W. The type of exposure apparatus EX is not limited to an exposure apparatus for manufacturing semiconductor elements that exposes a semiconductor element pattern onto a wafer W, and the present invention may also be applied to exposure apparatuses for manufacturing liquid crystal display elements or for manufacturing displays, thin-film magnetic heads, image pickup devices (CCD), micro machines, MEMS, DNA chips, or exposure apparatuses that are used to manufacture reticles or masks.

Moreover, in each of the above described embodiments, the description uses an exposure apparatus provided with the projection optical system PL as an example, however, the present invention may also be applied to exposure apparatuses and exposure methods that do not use the projection optical system PL. Even in cases when a projection optical system is not used, exposure light is irradiated onto a substrate via optical components such as a mask or a lens, and a liquid immersion area is formed in a predetermined space between these optical components and the substrate.

Note also that, in the above described embodiments, an optically transparent mask that is obtained by forming a predetermined light-shielding pattern (or a phase pattern or light-reducing pattern) on an optically transparent substrate is used, however, instead of this mask, as is disclosed, for example, in United States Patent No. 6,778,257, it is also possible to use an electronic mask (also known as a variable mold mask and including, for example, digital micro-mirror devices (DMD) which are a type of non-emission image display element (i.e., spatial optical modulator) that forms a transmission pattern or a reflection pattern or a light-emission pattern based on electronic data for the pattern to be exposed.

Furthermore, as is disclosed, for example, in Japanese Patent Application, Publication No. 2004-519850 (corresponding to United States Patent No. 6,611,316), the present invention can also be applied to an exposure apparatus that synthesizes the patterns of two masks on a substrate via a projection optical system, and performs a double exposure substantially simultaneously of one shot area on the substrate by means of a single scan exposure.

When a linear motor is used for the wafer stage WST and/or the reticle stage RST (see USP No. 5,623,853 or USP No. 5,528,118), then it is possible to use either an air flotation type that uses air bearings, or a magnetic flotation type that uses Lorentz's force or reactance force. The respective stages WST and RST may also be either a type that moves along guides or a guideless type that is not provided with guides. As the drive mechanism for the respective stages RST and WST, it is possible to use a planar motor in which a magnet unit in which magnets are arranged two-dimensionally, and an armature unit in which coils are arranged two-dimensionally are arranged facing each other, and that drives the respective stages RST and WST using magnetic force. In this case, either the magnet unit or the armature unit may be connected to either the stage WST or the stage RST, and the other one of the magnet unit and the armature unit may be provided on the moving surface side of the other one of the stage WST and the stage RST.

As is disclosed in Japanese Patent Application, Publication No. H08-166475 (USP No. 5,528,118), it is also possible to allow the reaction force generated by the movement of the wafer stage WST to escape mechanically to the floor (i.e., to the ground) using a frame component so that it is not transmitted to the projection optical system PL. As is disclosed in Japanese Patent Application, Publication No. H08-330224 (USP No. 5,874,820), it is also possible to allow the reaction force generated by the movement of the reticle stage RST to escape mechanically to the floor (i.e., to the ground) using a frame component so that it is not transmitted to the projection optical system PL.

As far as is permitted by the law of the countries specified or selected in this patent application, the disclosures in all of the Japanese Patent Publications and U.S. Patents related to exposure apparatuses and the like cited in the above respective embodiments and modified examples, are incorporated herein by reference.

As has been described above, the exposure apparatus EX of the present embodiment is manufactured by assembling various subsystems which contain the respective component elements such that they maintain a predetermined mechanical accuracy, electrical accuracy, and optical accuracy. In order to ensure each of these accuracies, concurrently with the assembling, adjustments are made in order to achieve optical accuracy for the various optical systems, adjustments are made in order to achieve mechanical accuracy for the various mechanical systems, and adjustments are made in order to achieve electrical accuracy for the various electrical systems. The steps to assemble an exposure apparatus from the various subsystems include making mechanical connections, electrical circuitry wiring connections, and air pressure circuitry tube connections and the like between the various subsystems. It is to be understood that, prior to the steps to assemble an exposure apparatus from the various subsystems, steps are performed in order to assemble each of the respective subsystems. After the steps to assemble an exposure apparatus from the various subsystems have ended, comprehensive adjustments are made so that the various accuracies are secured in the overall device. Note that it is desirable for the exposure apparatus to be manufactured in a clean room where the temperature and cleanliness are controlled.

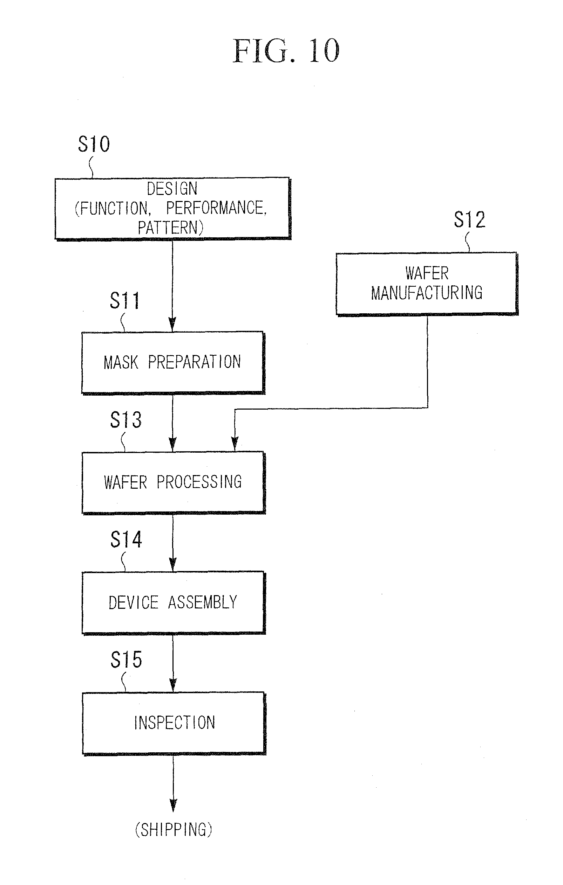

FIG. 10 is a flowchart showing an example of a process to manufacture a micro device (i.e., a semiconductor chip such as an IC or LSI, a liquid crystal panel, a CCD, a thin film magnetic head, or a micro machine or the like). As is shown in FIG. 11, a micro device such as a semiconductor device is manufactured by undergoing step S11 in which the functions and capabilities of the micro device are designed, a step S12 in which a mask (i.e., a reticle) is prepared based on the design step, a step S 13 in which a substrate (i.e., a wafer) is manufactured as the base material of the device, a step S14 that includes substrate processing such as a step in which the pattern of the mask is transferred onto the substrate using the exposure apparatus EX of the above described embodiment, a step in which the exposed substrate is developed, and a step in which heating (i.e., curing) and etching of the developed substrate are performed, a step S 15 in which the device is assembled (including working processes such as a dicing step, a bonding step, and a packaging step), and an inspection step S16 and the like.

## Claims

1. An exposure apparatus comprising:
a first stage;
a second stage;
a maintenance apparatus that performs maintenance on the second stage; and
a control apparatus that causes the maintenance performed by the maintenance apparatus to be executed during exposure processing of a substrate that is placed on the first stage.

2. The exposure apparatus according to claim 1, wherein there are further provided:
a projection optical system that projects a pattern image onto the substrate;
a first drive apparatus that is able to move the first stage to a position facing the projection optical system; and
a second drive apparatus that is able to move the second stage to a position facing the projection optical system.

3. The exposure apparatus according to claim 1 or 2, wherein the second stage is a measurement stage that makes measurements relating to exposure.

4. The exposure apparatus according to any of claims 1 to 3, wherein the maintenance apparatus cleans the second stage.

5. The exposure apparatus according to claim 4, wherein
the maintenance apparatus comprises a supply apparatus that supplies cleaning agent to the second stage; and a recovery apparatus that recovers the cleaning agent.

6. The exposure apparatus according to claim 4, wherein the maintenance apparatus comprises a photochemical cleaning apparatus that irradiates ultraviolet light onto at least a portion of the area of the second stage.

7. The exposure apparatus according to any one of claims 1 to 6, wherein
the second stage comprises a replaceable component that is able to be replaced; and
the maintenance apparatus replaces the replaceable component.

8. The exposure apparatus according to claim 7, wherein
the maintenance apparatus comprises an adjustment apparatus that adjusts the position of the replaceable component relative to the second stage.

9. The exposure apparatus according to claim 7, wherein
a liquid repellent coating is coated on at least a portion of the second stage, and
the maintenance apparatus performs maintenance on the liquid repellent coating.

10. An exposure apparatus comprising:
a first stage;
a second stage; and
a temperature control apparatus that controls the temperature of at least one of the first stage and the second stage by controlling the flow of gas in a space between the first stage and the second stage.

11. The exposure apparatus according to claim 10, wherein the temperature control apparatus is provided in the first stage or the second stage.

12. The exposure apparatus according to claim 10, wherein the temperature control apparatus supplies a gas that has been adjusted to a predetermined temperature to the space between the first stage and the second stage.

13. The exposure apparatus according to claim 10, wherein the temperature control apparatus suctions gas from the space between the first stage and the second stage.

14. The exposure apparatus according to claim 10, wherein the temperature control apparatus is provided with a baffle component that guides a gas flowing through another space into the space between the first stage and the second stage.

15. A device manufacturing method that includes a step of transferring a device pattern onto a substrate using the exposure apparatus according to any one of claims 1 to 14.

16. An exposure method for exposing a substrate, the method comprising:
executing predetermined processing by use of a first stage that holds the substrate, and
executing maintenance, during the predetermined processing, on a second stage that is different from the first stage.

17. The exposure method according to claim 16, wherein the second stage includes a measurement stage that makes measurements relating to exposure.

18. The exposure method according to claim 16 or 17, wherein the maintenance includes cleaning of the second stage.

19. The exposure method according to claim 18, wherein the cleaning is performed by supplying cleaning solution to a top surface of the second stage.

20. The exposure method according to claim 18, wherein the cleaning is performed by irradiating ultraviolet light onto the top surface of the second stage.

21. The exposure method according to any one of claims 16 to 20, wherein the predetermined processing includes exposure processing of the substrate held on the first stage.

22. A device manufacturing method comprising:
exposing the substrate using the exposure method according to any one of claims 16 to 21; and
performing developing processing on the exposed substrate.
